# FASCICULE DE BREVET EUROPEEN

(11) **EP 3 848 967 B1**
(45) Date de publication et mention de la délivrance du brevet: **03.06.2026**
(21) Numéro de dépôt: 21150859.3
(22) Date de dépôt: 11.01.2021
(51) Int. Cl.: H04N 23/20, H04N 25/76, H10F 39/12, H10F 39/00, H10F 77/20

(54) **DÉTECTEUR D'IMAGE À COLLECTION ÉLECTRONIQUE LATÉRALE**
BILDSENSOR MIT SEITLICHER ELEKTRONISCHER ERFASSUNG
IMAGE DETECTOR WITH LATERAL ELECTRONIC COLLECTION

(30) Priorité: 13.01.2020 FR 2000262
(43) Date de publication de la demande: 14.07.2021
(73) Titulaire: New Imaging Technologies, 91370 Verrières-le-Buisson (FR)
(72) Inventeur: Noguier, Vincent, 92340 Bourg-la-Reine (FR); Ferré, Simon, 91300 Massy (FR)
(74) Mandataire: Ipsilon

(56) Documents cités:
- WO-A2-2007/091031
- US-A1- 2005 161 670
- US-A1- 2011 297 915
- US-A1- 2016 119 562
- US-A1- 2017 162 617

## Description

### Domaine technique

La présente invention concerne les capteurs d'image en général, et plus particulièrement et non exclusivement les capteurs d'image pour le visible et l'infrarouge à ondes courtes « Short Wave Infrared » (SWIR), à savoir entre 900 nm et 1700 nm.

### Technique antérieure

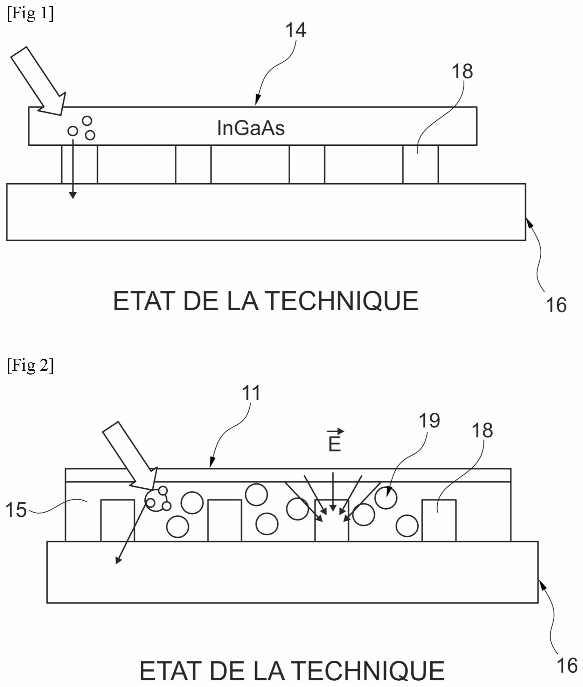

On connaît des capteurs SWIR à base d'un matériau semi-conducteur cristallin, tel que l'InGaAs. Une telle structure photosensible est représentée très schématiquement à la figure 1.

La lumière est absorbée par le matériau semi-conducteur (InGaAs) 14, puis les électrons ainsi générés sont transmis dans chaque pixel du circuit de lecture 16 (« Read Out Integrated Circuit » *ROIC*) via des électrodes sous forme de billes métalliques 18 qui assurent également l'intégrité mécanique de l'ensemble. Il s'agit de l'approche la plus courante dans les détecteurs du commerce. Le principe est identique pour d'autres longueurs d'ondes et matériaux (HgCdTe, InSb, etc.)

Une deuxième approche pour l'imagerie IR est de remplacer le matériau semi-conducteur 14 par des nanocristaux dispersés (points quantiques, plus couramment appelés « Colloidal Quantum Dots » (CQD)). Cela permet d'avoir potentiellement une solution à moindre coût de fabrication, ainsi qu'une sensibilité à d'autres longueurs d'onde.

Une structure photosensible fonctionnant selon cette deuxième approche est illustrée à la figure 2. Lorsque la lumière est absorbée, les électrons sont générés au niveau des CQD 19 dans une matrice de polymère 15. Un champ électrique *̅E̅*̅, dont la résultante est dirigée selon la normale au plan du capteur, est appliqué grâce à une couche métallique externe 11 déposée sur la matrice de polymère 15. Ce champ électrique permet de collecter les électrons générés au niveau de chaque pixel du circuit de lecture 16, toutes les électrodes de collecte 18 associées aux pixels étant au même potentiel.

Les demandes de brevet US 2016/0181325 et US 2016/119562 décrivent un capteur d'image fonctionnant selon cette deuxième approche.

Le problème d'une telle architecture est que la couche métallique absorbe et réfléchit une partie de la lumière incidente, ce qui réduit la sensibilité du capteur et complexifie la fabrication.

### Exposé de l'invention

Il existe donc un besoin pour perfectionner encore les capteurs d'image, et notamment résoudre ce problème.

L'invention vise à y répondre, selon un premier de ses aspects, grâce à un procédé de fonctionnement d'un capteur d'image selon la revendication 1, comportant un milieu comprenant au moins un matériau photosensible apte à générer des charges par effet photoélectrique lorsque le capteur est exposé à une lumière incidente, et des électrodes de collecte au contact dudit milieu, associées à des circuits de pixels, procédé dans lequel on crée au moins un champ électrique ayant une composante latérale pour collecter lesdites charges sur au moins l'une desdites électrodes de collecte, permettant leur lecture par le circuit de pixel associé, et dans lequel ledit champ électrique est généré en créant au moins une différence de potentiel entre ladite électrode de collecte et au moins une autre zone du capteur, portée à un potentiel différent, cette autre zone étant située entre au moins deux électrodes de collecte.

Grâce à l'invention et à la composante latérale du champ créée par la différence de potentiel entre ladite électrode de collecte et ladite au moins une autre zone du capteur, il est possible de se passer d'une électrode externe sous forme de couche métallique déposée sur le dessus du milieu comprenant le matériau photosensible.

L'invention permet ainsi de récolter plus de lumière et d'améliorer les performances du capteur, notamment sa sensibilité. De plus, la fabrication du capteur peut s'en trouver facilitée, car l'étape de dépôt de la couche externe précitée n'est plus nécessaire.

Cette autre zone est une autre électrode de collecte, qui n'est alors pas utilisée pour collecter les charges pendant la génération du champ électrique, ou toute autre électrode ou ensemble d'électrodes dédié à la génération de ce champ.

On peut changer séquentiellement l'orientation de la composante latérale du champ électrique pour collecter séquentiellement les charges sur des électrodes de collecte respectives différentes. Cela permet d'utiliser une partie des électrodes de collecte existantes comme électrodes de champ, pour la création du champ électrique. Ainsi, il est possible si on le souhaite, par exemple pour minimiser les frais de développement du capteur, de mettre en œuvre l'invention avec une disposition d'électrodes de collecte conventionnelle, sans avoir à intégrer des électrodes de champ additionnelles.

Pour changer l'orientation de la composante latérale du champ électrique résultant, on peut soumettre différentes électrodes à des potentiels différents de manière séquentielle. Cela permet de reconstruire, avec deux images consécutives partielles comportant l'information obtenue avec une partie seulement des pixels, une image complète avec l'information provenant de tous les pixels. On peut ainsi obtenir une résolution équivalente si l'on réduit la fréquence d'acquisition des images, par rapport à un capteur conventionnel où toutes les électrodes de collecte sont utilisées pour l'acquisition d'une même image.

Dans des exemples de mise en œuvre, on soumet alternativement au moins deux électrodes adjacentes à des potentiels différents de façon à collecter alternativement les charges sur lesdites électrodes. Ceci permet de maximiser l'intensité du champ créé en profitant de la proximité des électrodes entre lesquelles ce champ est généré.

Les charges sont préférentiellement collectées sur une électrode de collecte donnée à l'aide d'un champ électrique ayant une composante latérale et qui est généré entre celle-ci et au moins une autre électrode portée à un potentiel différent, de préférence au moins deux autres électrodes portées à un potentiel différent, ces deux autres électrodes étant notamment équidistantes de l'électrode de collecte. Cela permet de drainer les charges présentes dans ledit milieu, autour de l'électrodes de collecte, vers cette dernière. Dans des exemples de mise en œuvre de l'invention, au moins l'une de ces autres électrodes est utilisée ensuite comme électrode de collecte, l'électrode ayant servi précédemment d'électrode de collecte ne servant plus d'électrode de collecte et servant à générer le champ électrique.

Les électrodes de collecte sont préférentiellement agencées selon une disposition matricielle, des potentiels différents V1, V2 étant par exemple appliqués sur les électrodes selon un agencement en damier, de manière à générer des champs électriques ayant une composante latérale non nulle. De préférence, le potentiel de chaque électrode de collecte passe alternativement du premier potentiel V1 au deuxième V2 et inversement. Etant donné que, pour un motif de potentiels V1, V2 appliqués, seule la moitié des pixels est active avec des électrodes correspondantes servant à récolter les charges, et donc à constituer une image, l'inversion du damier d'une image à l'autre permet de changer les potentiels des électrodes des pixels en rendant active l'autre moitié des pixels qui était précédemment inactive. Ainsi, avec deux images partielles consécutives imbriquées, on peut reconstruire une image complète avec l'information provenant de tous les pixels.

Alternativement, au moins une électrode dédiée est utilisée exclusivement comme électrode de champ pour générer ledit champ électrique, sans jamais servir à collecter de charges lues par le circuit de pixel associé. Ainsi, grâce à ces électrodes de champ additionnelles dédiées, dans le cas où les électrodes de collecte sont disposées selon un agencement matriciel, toutes les électrodes de collecte peuvent être au même potentiel lorsque les circuits de pixels le permettent.

Dans cette variante, tous les pixels étant actifs lors de la capture d'une même image, il n'est plus nécessaire de soumettre les électrodes de collecte séquentiellement à des potentiels différents pour qu'elles servent d'électrodes de champ et l'image produite contient l'information complète pour tous les pixels. Cette solution évite de perdre en résolution lors de l'acquisition d'une image, mais peut rendre la conception du capteur plus complexe du fait de l'ajout de ces électrodes de champ.

Ladite au moins une électrode de champ, et mieux chaque électrode de champ, est située entre au moins deux électrodes de collecte, notamment à équidistance de celles-ci, un champ ayant une composante latérale non nulle étant généré entre chacune de ces électrodes de collecte et l'électrode de champ.

Les électrodes de champ sont préférentiellement disposées uniformément entre les électrodes de collecte, par exemple de manière qu'une électrode de champ est entourée par quatre électrodes de collecte adjacentes. Cette disposition permet une collecte de charges uniforme par les électrodes de collecte.

De préférence, ladite au moins une électrode de champ et mieux chaque électrode de champ a une section inférieure à celle de l'électrode de collecte, lorsque le capteur est observé de face. Cela permet de ne pas perdre en résolution à taille de matrice de pixels constante.

Le champ électrique généré pour la collecte des charges au sein dudit milieu peut présenter différents profils temporels, en fonction, par exemple, de l'application visée.

Le champ électrique peut être notamment pulsé durant la lecture d'un pixel, ce qui peut permettre de limiter la consommation électrique et l'échauffement. Autrement dit, lors de la lecture d'un pixel, l'électrode de champ ne garde pas le même potentiel durant toute la durée de la lecture de ce pixel, et son potentiel présente par exemple au moins deux créneaux successifs.

Le capteur peut comporter tous circuits de pixels adaptés à lire les charges collectées par les électrodes de collecte, et notamment des circuits de pixels de type amplificateur drain commun (« Source Follower ») en mode linéaire ou logarithmique, de type amplificateur de charge à colonne (« Capacitive Trans-Impedance Amplifier » (CTIA)) ou de type à injection directe (« Direct Injection »), ces circuits étant connus en eux-mêmes et par exemple décrits dans la publication « Focal-Plane-Arrays and CMOS Readout Techniques of Infrared Imaging Systems », IEEE Transactions on circuits and systems for video technology, vol 7, No 4, August 1997.

De préférence, au moins un interrupteur de RESET est monté en parallèle du circuit de pixel de sorte, lorsque fermé, à imposer une tension prédéfinie à l'électrode associée pour lui permettre de générer le champ électrique recherché.

La lecture des pixels peut s'effectuer en mode obturateur global (« Global Shutter ») ou en mode obturateur déroulant (« Rolling Shutter »).

Au moins l'une des électrodes servant à générer le champ électrique à composante latérale non nulle peut être polarisée par l'application d'une tension constante pendant le temps d'exposition du pixel correspondant. L'électrode qui est ainsi polarisée peut être l'électrode de champ ou une électrode de collecte utilisée en tant qu'électrode de champ. Cela peut encore être l'électrode de collecte elle-même, lorsque cela est compatible avec le fonctionnement du circuit de pixel, par exemple lorsque le circuit de pixel est de type CTIA. Cela peut encore être les deux, à la fois l'électrode de collecte et la ou les électrodes adjacentes utilisées pour créer le champ avec l'électrode de collecte.

Cette électrode peut être polarisée avant le début du temps d'exposition avec une tension qui est inverse de celle de la polarisation pendant le temps d'exposition. Ceci permet de limiter tout phénomène de rémanence des charges en chassant les charges piégées dans les défauts. Au moins l'une des électrodes servant à générer le champ électrique à composante latérale non nulle peut être polarisée par l'application d'une tension pulsée pendant le temps d'exposition, comme mentionné plus haut. Ceci permet d'optimiser la consommation énergétique et de réduire l'échauffement du capteur.

Cette électrode peut notamment être polarisée avant le début du temps d'exposition et/ou cesser d'être polarisée avant la fin du temps d'exposition.

De préférence, les électrodes, notamment celles de collecte, sont métalliques.

Les électrodes, notamment celles de collecte, peuvent comporter un ou plusieurs métaux choisis parmi : Al ; Al/TiW ; In ; Au ; Ti/Au ; Ti/Pt/Au ; Cu ; Cu/Au ; Ni ; Ni/Au ; Cr ; AuSn et leurs mélanges.

Les électrodes, notamment celles de collecte, sont de préférence de contour circulaire en vue de face, étant notamment sous forme de billes. Alternativement, les électrodes, notamment celles de collecte, sont sous forme de structures imbriquées, notamment sous forme de peignes.

Les électrodes, notamment celles de collecte, sont préférentiellement déposées sur un circuit de lecture du capteur comprenant les circuits de pixels, avant le dépôt dudit milieu.

Les électrodes, notamment celles de collecte, peuvent être déposées par évaporation, par pulvérisation cathodique (« sputtering »), par usinage, par croissance électrolytique ou par plaquage métallique.

Les électrodes, notamment celles de collecte, peuvent être formées par une couche métallique supérieure d'un circuit de lecture du capteur comprenant les circuits de pixels, présente en sortie de fonderie du capteur, notamment une couche métallique supérieure protégée ou non par une couche de passivation ouverte au niveau des électrodes.

Le matériau photosensible comporte de préférence des nanocristaux, de préférence des points quantiques (Quantum dots), notamment colloïdaux ou du graphène, dispersés dans le milieu.

Le matériau photosensible peut comporter un semi-conducteur amorphe, cristallin ou semi-cristallin.

Le matériau photosensible peut être déposé sous forme d'une ou plusieurs couches empilées au-dessus des électrodes. Le matériau photosensible peut, en variante, être disposé sous forme d'une ou plusieurs couches s'étendant dans le sens de l'épaisseur entre les électrodes. L'ajout de couches supplémentaires permet d'optimiser les performances en améliorant le transport des porteurs de charge photo-générés, ou en réduisant la distance que doivent parcourir les paires électrons-trous avant d'être dissociées. Ces couches supplémentaires peuvent également permettre un fonctionnement multispectral du capteur, par exemple à deux longueurs d'onde différentes.

Le matériau photosensible peut encore être intriqué et disposé de manière non ordonnée dans ledit milieu.

L'invention a également pour objet, selon un autre de ses aspects, un capteur d'image selon la revendication 13, notamment pour la mise en œuvre du procédé selon l'invention tel que défini ci-dessus, comportant un milieu comprenant au moins un matériau photosensible apte à générer des charges par effet photoélectrique lorsque le capteur est exposé à une lumière incidente, et des électrodes de collecte au contact dudit milieu, associées à des circuits de pixels, le milieu ayant une face opposée à celle en contact avec les électrodes de collecte qui est dépourvue de couche métallique, les circuits de pixels étant configurés pour créer au moins un champ électrique ayant une composante latérale pour collecter lesdites charges sur au moins l'une desdites électrodes de collecte.

Ce champ électrique peut notamment être créé entre deux électrodes disposées au niveau des circuits de pixels, par exemple entre une électrode de collecte et des électrodes de collecte adjacentes, ou entre une électrode de collecte et une ou plusieurs électrodes de champ dédiées, comme détaillé plus haut.

Le capteur d'image peut présenter tout ou partie des caractéristiques précédemment décrites. L'invention a aussi pour objet, selon un autre de ses aspects, une structure photosensible pour capteur d'image selon l'invention, comportant :
- des électrodes de collecte, et
- un milieu comprenant un matériau photosensible apte à générer des charges électriques par effet photoélectrique, ayant une face en contact avec les électrodes et une face opposée exposée à la lumière qui est dépourvue de couche métallique.

Un tel milieu peut notamment comporter des nanocristaux, comme mentionné plus haut.

La structure peut comporter des électrodes de champ dédiées, telles que définies ci-dessus. L'invention a également pour objet, selon un autre de ses aspects, un procédé de fabrication d'un capteur d'image selon l'invention, comportant le dépôt dudit milieu sur les électrodes de collecte, ce dépôt étant effectué selon une méthode choisie parmi : le revêtement par centrifugation (« spin-coating »), l'impression par jet d'encre (« inkjet printing »), la projection (« spray-coating ») et le dépôt goutte à goutte (« drop casting »).

### Brève description des dessins

L'invention pourra être mieux comprise à la lecture de la description détaillée qui va suivre, d'exemples non limitatifs de mise en œuvre de celle-ci, et à l'examen du dessin annexé, sur lequel :
[Fig 1] la figure 1, précédemment décrite, représente schématiquement une première structure photosensible d'un capteur d'image de l'art antérieur,
[Fig 2] la figure 2, précédemment décrite, illustre schématiquement une deuxième structure photosensible d'un capteur d'image de l'art antérieur,
[Fig 3] la figure 3 représente schématiquement, en vue de côté, un exemple d'une structure photosensible selon l'invention,
[Fig 4] la figure 4 représente schématiquement, en vue de dessus, la structure photosensible de la figure 3, ayant une matrice d'électrodes avec un motif en damier des potentiels appliqués,
[Fig 5] la figure 5 illustre schématiquement, en vue de dessus, une structure photosensible selon l'invention, ayant une matrice d'électrodes avec des électrodes de champ,
[Fig 6] la figure 6 représente schématiquement un exemple de répartition des transistors de RESET des circuits de pixels,
[Fig 7] la figure 7 représente schématiquement, en vue latérale, une structure photosensible selon l'invention, avec des couches de matériau semi-conducteur empilées au-dessus des électrodes,
[Fig 8] la figure 8 est une vue latérale schématique d'une structure photosensible selon l'invention avec des couches de matériau semi-conducteur s'étendant dans le sens de l'épaisseur entre les électrodes,
[Fig 9] la figure 9 est une vue latérale schématique d'une structure photosensible selon l'invention, avec du matériau semi-conducteur intriqué et disposé de manière non ordonnée dans ledit milieu,
[Fig 11a] la figure 11a représente schématiquement, en vue de dessus, une structure photosensible selon l'invention, sans ajout d'électrodes,
[Fig 11b] la figure 11b illustre schématiquement, en vue de côté, la structure photosensible de la figure 11a,
[Fig 12a] la figure 12a représente schématiquement, en vue de dessus, une structure photosensible selon l'invention, avec des électrodes sous forme de billes,
[Fig 12b] la figure 12b illustre schématiquement, en vue de côté, la structure photosensible de la figure 12a,
[Fig 13a] la figure 13a représente schématiquement, en vue de dessus, une structure photosensible selon l'invention avec des électrodes sous forme de structures imbriquées,
[Fig 13b] la figure 13b illustre schématiquement, en vue de côté, la structure photosensible de la figure 13a,
[Fig 14a] la figure 14a est un premier exemple de chronogramme illustrant une façon de polariser l'électrode de champ,
[Fig 14b] la figure 14b est un deuxième exemple de chronogramme illustrant une autre façon de polariser l'électrode de champ,
[Fig 14c] la figure 14c est un troisième exemple de chronogramme illustrant une façon de polariser l'électrode de champ,
[Fig 14d] la figure 14d est un quatrième exemple de chronogramme illustrant une autre façon de polariser l'électrode de champ,
[Fig 14e] la figure 14e est un cinquième exemple de chronogramme illustrant une autre façon de polariser l'électrode de champ, et
[Fig 15] la figure 15 est un schéma simplifié montrant les circuits de pixels et les transistors permettant la mise sous un potentiel prédéfini des électrodes

### Description détaillée

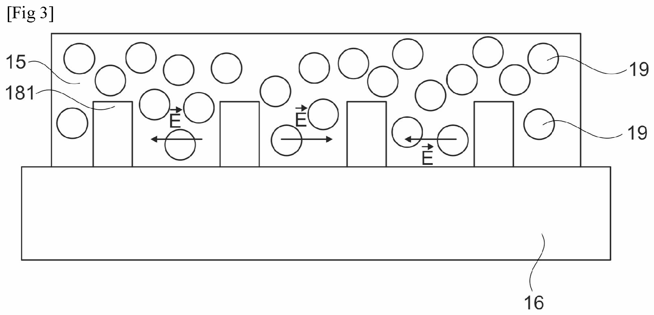

La figure 3 représente schématiquement, en vue de côté, un exemple d'une structure photosensible selon l'invention, comportant un circuit de lecture 16 présentant des électrodes de collecte 181 au contact d'un milieu 15 déposé sur le circuit de lecture 16, et comprenant un matériau photosensible 19.

Le circuit de lecture 16 est agencé pour générer une différence de potentiel entre un premier ensemble 181a desdites électrodes et un deuxième ensemble 181b desdites électrodes , afin d'avoir un champ électrique *̅E̅*̅ ayant une composante latérale non nulle pour collecter les charges générées dans le milieu par effet photoélectrique, et de pouvoir se passer d'une couche métallique supérieure d'électrode, contrairement à l'art antérieur décrit en référence à la figure 2.

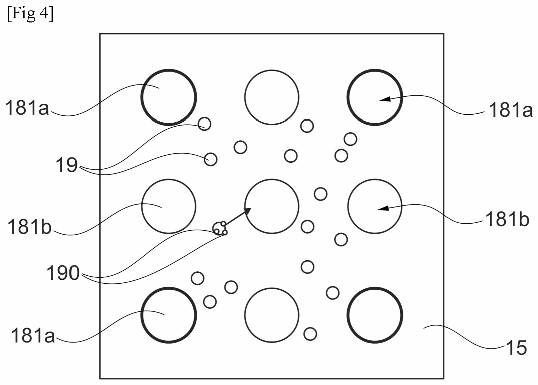

La figure 4 représente schématiquement, en vue de dessus, la structure photosensible de la figure 3, où les électrodes de collecte 181 sont agencées selon une disposition matricielle au contact du milieu 15.

Les électrodes de collecte 181 sont reliées à des circuits de pixels respectifs, permettant d'amplifier le courant collecté par celles-ci et de générer ainsi un signal de sortie représentatif de l'éclairement des pixels correspondants.

Le matériau photosensible 19 est par exemple sous forme de CQD dispersés dans le milieu 15, lequel comporte un polymère isolant électrique.

Pour générer le champ électrique recherché, des potentiels différents V1, V2 peuvent être appliqués sur les électrodes 181 selon un motif en damier. Par exemple, si les circuits de pixels le permettent, les électrodes 181a sont soumises à un même instant à un même premier potentiel V1 tandis que les électrodes 181b sont soumises à un même second potentiel V2, différent du premier.

Par exemple, la différence de potentiel entre V1 et V2 permet de générer des champs électriques locaux dans le voisinage de chaque électrode de collecte 181a, ayant une composante latérale non nulle, déplaçant les charges générées par effet photoélectrique vers celle-ci. Les charges 190 générées par effet photoélectrique au niveau des CQD sont alors collectées par les électrodes de collecte 181a. Dans le cas où les charges 190 sont des électrons, le potentiel V1 des électrodes 181a recueillant ces électrons est alors supérieur au potentiel V2 des électrodes 181b.

Dans cet exemple, seule la moitié des électrodes de collecte 181, à savoir les électrodes 181a, est ainsi active à un instant donné pour recueillir les charges générées par effet photoélectrique. Donc, pour récupérer l'information manquante des autres pixels correspondant aux électrodes 181b, on inverse les potentiels V1 et V2 séquentiellement d'une image à l'autre, c'est-à-dire que les électrodes 181a auxquelles était précédemment appliqué le potentiel V1 se voient appliquer le potentiel V2, et vice versa. Alors, les électrodes 181a cessent d'être actives et les charges sont collectées par les électrodes 181b. Ensuite les électrodes 181b cessent à nouveau d'être actives et les charges sont collectées par les électrodes 181a, et ainsi de suite.

Ainsi, il est possible de reconstruire, avec deux images consécutives moins résolues comportant l'information pour la moitié seulement des pixels du capteur, une image plus résolue avec l'information complète pour tous les pixels.

Par ailleurs, il est possible d'avoir des tensions V1 et V2 toutes les deux positives, ou les deux négatives, ou l'une positive et l'autre négative, pourvu qu'il y ait une différence de potentiel suffisante pour créer un champ électrique latéral permettant la collecte des charges.

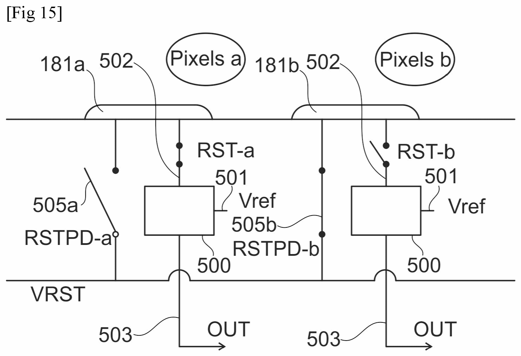

La figure 15 représente schématiquement un exemple de circuit permettant d'assurer la lecture des pixels et la mise des électrodes aux potentiels souhaités.

Sur cette figure, les électrodes de collecte 181a sont associées aux pixels « *a* » et les électrodes de collecte 181b sont associées aux pixels « *b* ».

Quel que soit le type d'architecture du circuit de pixel 500 (type amplificateur drain commun (« Source Follower ») en mode linéaire ou logarithmique, type amplificateur de charge à colonne (« Capacitive Trans-Impedance Amplifier » (CTIA)) ou de type à injection directe (« Direct Injection »(DI)), il possède classiquement deux entrées : une première entrée 501 connectée à une tension de référence Vref et une deuxième entrée 502 connectée à l' électrode 181a ou 181b via un interrupteur optionnel RSTa ou RSTb. La sortie 503 du circuit de pixel est notée « OUT ». Un interrupteur 505a (RSTPDa) ou 505b (RSTPDb), constitué par exemple par un transistor, est monté en dérivation du circuit de pixel 500 reliant l'électrode 181a ou 181b à une ligne de tension de potentiel prédéfini VRST.

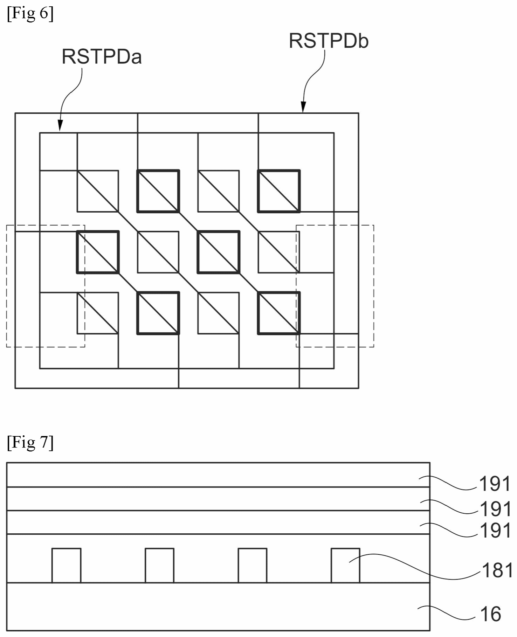

La figure 6 illustre en vue de dessus un exemple de connexion des interrupteurs 505. Tous les interrupteurs 505a associés aux électrodes de collecte 181a peuvent être reliés ensemble par des connexions parallèles à une même ligne RSTPDa, comme illustré à la figure 6, tandis que les autres interrupteurs 505b associés aux électrodes de collecte 181b sont reliés à une autre ligne RSTPDb, par des connexions qui s'imbriquent entre celles de la ligne RSTPDa. Pendant une première phase, les interrupteurs 505a et RST-b sont ouverts et les interrupteurs 505-b et RST-a sont fermés, portant ainsi les électrodes 181a à un potentiel inférieur à VRST, et les électrodes 181b à un potentiel égal à VRST.

Pendant cette phase, les pixels b peuvent également être réinitialisés pendant que les pixels *a* sont intégrés, en fermant l'interrupteur RST-b.

Pendant une deuxième phase, les interrupteurs 505-a et RST-b sont fermés et les interrupteurs 505-b et RST-a sont ouverts, portant ainsi les électrodes 181a à un potentiel égal à VRST, et les électrodes 181b à un potentiel inférieur à VRST.

Pendant cette phase, les pixels *a* peuvent également être réinitialisés pendant que les pixels b sont intégrés, en fermant l'interrupteur RST-a.

Dans une architecture de circuit de pixel 500 de type CTIA, la tension de référence Vref est fixe et la tension aux bornes de la photodiode associée à ce circuit, quand l'interrupteur 505 correspondant est ouvert, devient VRST-Vref.

Dans une architecture de circuit de pixel 500 de type « Source Follower », la tension aux bornes de la photodiode se stabilise progressivement pour tangenter VRST, quand l'interrupteur 505 correspondant est ouvert.

Les phases précitées d'ouverture et de fermeture des interrupteurs 505a et 505b, et inversement, se succèdent pour former le motif en damier des tensions appliquées susmentionné.

On peut utiliser, dans une variante, toujours une même partie seulement des électrodes 181 comme pixels actifs, par exemple les électrodes 181a, l'autre partie servant en permanence d'électrodes de champ.

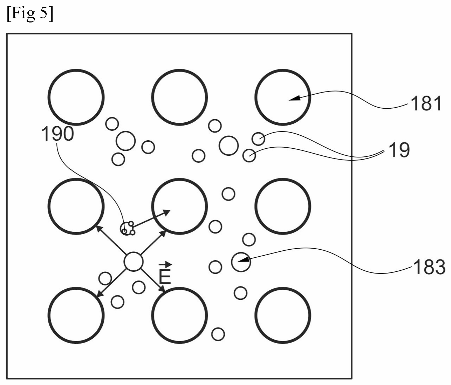

Dans une autre variante, représentée à la figure 5, des électrodes dédiées 183 sont utilisées comme électrodes de champ pour générer le champ électrique sans servir à collecter de charges lues par les circuits de pixel associés, en plus des électrodes de collecte 181. Les électrodes de collecte 181 peuvent alors être au début de chaque exposition à un même potentiel, qui est différent de celui appliqué sur les électrodes de champ 183 lors de la lecture. Les électrodes de champ 183 sont de préférence, comme illustré, disposées uniformément entre les électrodes de collecte 181, de sorte qu'une électrode de champ 183 est entourée par quatre électrodes de collecte adjacentes 181. Cette disposition permet une collecte de charges uniforme.

Comme représenté sur cette figure, les électrodes de champ 183 ont de préférence une section inférieure à celle des électrodes de collecte, ce qui permet de ne pas nuire à la résolution du capteur en augmentant l'intervalle entre les électrodes de collecte 181. Diverses structures de milieu contenant le matériau photosensible peuvent servir à générer les charges par effet photoélectrique.

Les figures 7 à 9 illustrent des variantes où le matériau photosensible est un semi-conducteur disposé de différentes manières dans le matériau isolant.

La figure 7 représente schématiquement une structure photosensible avec des couches 191 de semi-conducteur empilées au-dessus des électrodes de collecte 181 déposées sur le circuit de lecture 16.

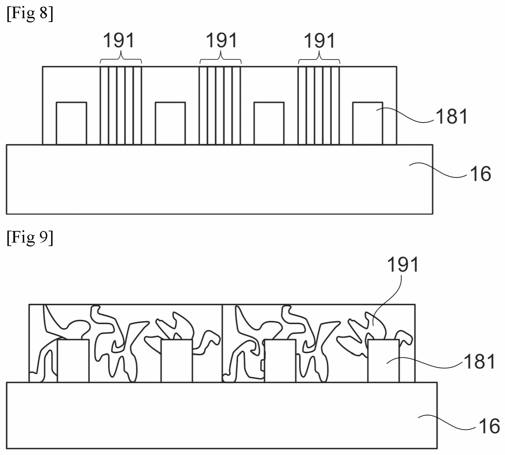

La figure 8 illustre une structure photosensible avec des couches 191 de semi-conducteur s'étendant dans le sens de l'épaisseur entre les électrodes de collecte 181.

Ces couches 191 de semi-conducteur décrites en rapport avec les figures 7 et 8 permettent d'optimiser les performances en améliorant le transport des charges photo-générées, ou en réduisant la distance que doivent parcourir les paires électrons-trous avant d'être dissociées. Ces couches supplémentaires peuvent également permettre un fonctionnement multispectral du capteur, par exemple à deux longueurs d'onde différentes.

La figure 9 représente schématiquement une structure photosensible avec un semi-conducteur 191 intriqué et disposé de manière non ordonnée dans le milieu 15.

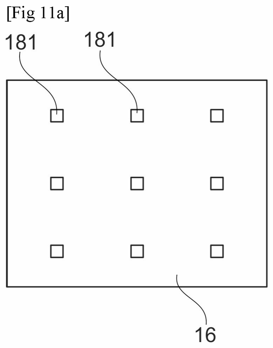

Les figures 11a, 12a et 13a représentent différents exemples d'électrodes de collecte 181 convenant à une structure photosensible selon l'invention.

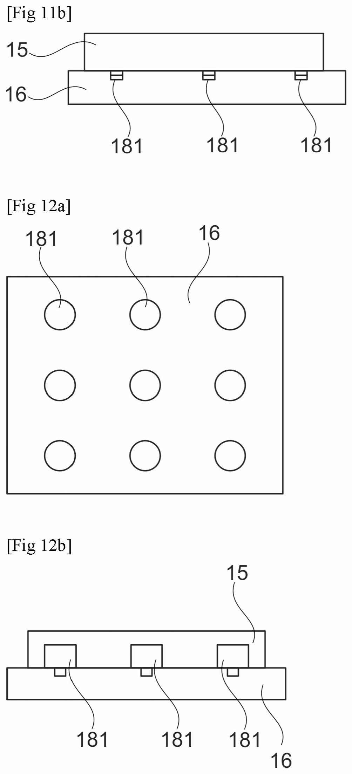

Les figures 11a et 11b illustrent une première variante où les électrodes de collecte 181 sont formées par une couche métallique supérieure du circuit de lecture 16, présente en sortie de fonderie du capteur. Cette couche métallique supérieure peut être protégée ou non par une couche de passivation (non représentée), ouverte au niveau des électrodes de collecte 181.

Les figures 12a et 12b représentent une deuxième variante où les électrodes de collecte 181 sont sous forme de billes, présentant un contour circulaire en vue de face.

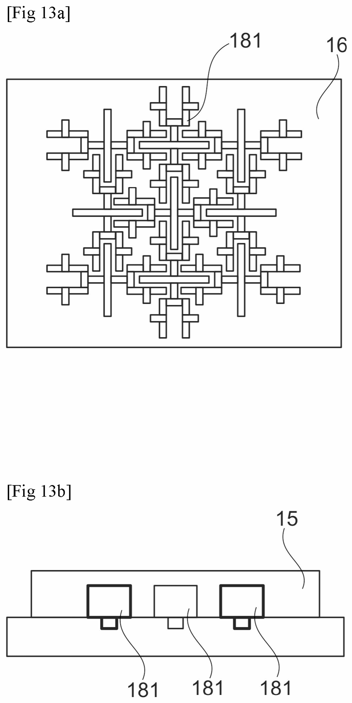

Les figures 13a et 13b illustrent une troisième variante où les électrodes de collecte 181 sont sous forme de structures imbriquées, par exemple sous forme de peignes imbriqués.

Dans les deuxième et troisième variantes, les électrodes sont par exemple déposées par évaporation, par pulvérisation cathodique (« sputtering »), par usinage, par croissance électrolytique ou par plaquage métallique.

Lorsque le capteur comporte des électrodes de champ, celles-ci peuvent également être formées par une couche métallique supérieure du circuit de lecture 16, par des billes ou plots, ou par des structures sous forme de peignes, imbriqués entre elles ou avec les électrodes de collecte. Ces électrodes de champ peuvent être déposées par toute technique conventionnelle, par exemple l'une de celles rappelées ci-dessus.

On peut appliquer aux électrodes du capteur servant à générer le champ électrique à composante latérale non nulle divers profils de tension dans le temps, de façon à créer la différence de potentiel recherchée entre elles.

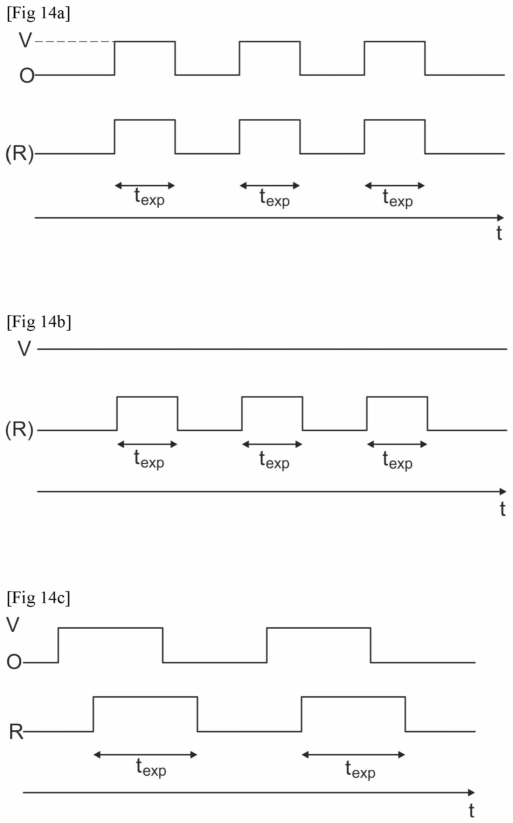

La figure 14a présente un exemple de chronogramme illustrant une possibilité parmi d'autres pour faire varier dans le temps la tension de polarisation V de l'électrode de champ, en fonction du signal de lecture R. Le signal de lecture R permet de commander la durée de l'exposition. La lecture des charges a lieu tant que le signal de lecture R est au niveau haut. La durée de maintien au niveau haut du signal R commande ainsi la durée d'exposition.

Dans l'exemple illustré à la figure 14a, pendant toute la durée de l'exposition tₑₓₚ, l'électrode de champ est polarisée à une tension constante V. Comme illustré à la figure 14b, la tension de l'électrode de champ est maintenue constamment à V y compris quand le signal de lecture R est au niveau bas, afin de réduire la consommation énergétique nécessaire aux commutations du niveau haut au niveau bas et vice versa.

Dans l'exemple illustré à la figure 14c, la polarisation de l'électrode de champ à la tension V commence juste avant l'exposition à la lumière du pixel associé et se termine juste avant la fin de l'exposition.

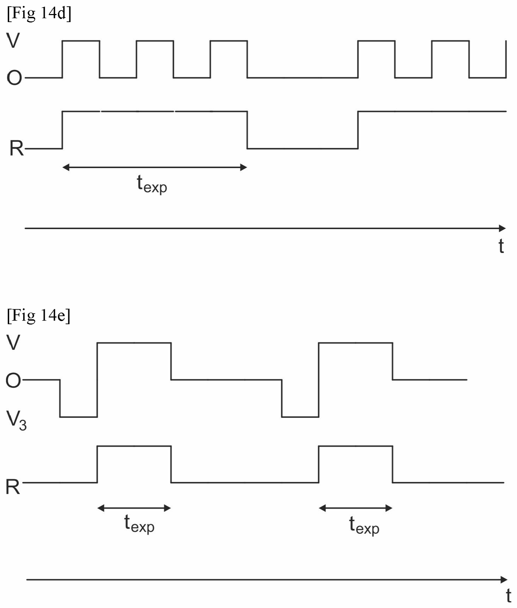

Dans l'exemple illustré à la figure 14d, l'électrode de champ est polarisée pendant toute la durée de l'exposition tₑₓₚ à une tension sous forme de créneaux d'amplitude V. Ceci permet de réduire la consommation énergétique et l'échauffement du capteur.

Dans l'exemple illustré à la figure 14e, l'électrode de champ, en plus d'être polarisée pendant toute la durée de l'exposition tₑₓₚ à la tension V, est polarisée à une tension de signe inverse V3 juste avant le début de l'exposition. Ceci réduit le phénomène de rémanence des charges en chassant les charges piégées dans les défauts. On a par exemple V3=-V.

L'invention n'est pas limitée aux exemples de réalisation décrits ci-dessus, ni aux capteurs SWIR. L'invention peut être utilisée notamment dans les capteurs infrarouge à mi-longueur d'onde « Mid-Wavelength Infrared » (MWIR) ou infrarouge à longue longueur d'onde « Long Wavelength Infrared » (LWIR) , moyennant l'emploi de matériaux photosensibles adaptés.

On peut permettre, le cas échéant, une possibilité de réglage au cours de l'utilisation du capteur des profils temporels et/ou amplitudes des tensions appliquées aux électrodes de champ et/ou de collecte, pour faire varier le champ électrique à composante latérale non nulle. On peut notamment réaliser le capteur pour permettre de modifier si on le souhaite, par voie logicielle par exemple, la différence de potentiel V2-V1 servant à générer le champ électrique à composante latérale, en fonction par exemple de l' *« auto-gating »* pour adapter la tension en fonction de l'intensité afin d'éviter la saturation du pixel, ou l'imagerie active à multi-impulsion en pilotant la différence de potentiel de façon synchronisée avec un laser pour un temps d'exposition plus long (e.g. Figure 14c), ou en faisant varier la différence de potentiel en fonction de la température ou du temps d'exposition pour avoir une correction de non-uniformité homogène et unique.

## Revendications

1. Procédé de fonctionnement d'un capteur d'image SWIR, MWIR ou LWIR, comportant un milieu (15) comprenant au moins un matériau photosensible (19 ; 191) apte à générer des charges (190) par effet photoélectrique lorsque le capteur est exposé à une lumière incidente, et des électrodes de collecte (181) au contact dudit milieu (15), associées à des circuits de pixels (500), le milieu (15) ayant une face opposée à celle en contact avec les électrodes de collecte (181) qui est dépourvue de couche d'électrode externe , procédé dans lequel on crée au moins un champ électrique uniquement à composante latérale pour collecter lesdites charges (190) sur au moins l'une desdites électrodes de collecte (181), permettant leur lecture par le circuit de pixel associé (500), dans lequel ladite composante latérale du champ électrique est générée en créant au moins une différence de potentiel entre ladite électrode de collecte (181) et au moins une autre zone du capteur étant une autre électrode de collecte ou une électrode de champ dédiée à la génération de ce champ,
portée à un potentiel différent, cette autre zone étant située entre au moins deux électrodes de collecte (181).

2. Procédé selon la revendication précédente, ladite au moins une autre zone étant une autre électrode de collecte, dans lequel on change séquentiellement l'orientation de la composante latérale du champ électrique pour collecter séquentiellement les charges sur des électrodes de collecte respectives différentes (181a, 181b), de préférence dans lequel on soumet alternativement au moins deux électrodes adjacentes (181a, 181b) à des potentiels différents de façon à collecter alternativement les charges sur lesdites électrodes, les charges étant notamment collectées sur une électrode de collecte (181a) donnée à l'aide d'un champ électrique ayant au moins une composante latérale et qui est généré entre celle-ci et au moins une autre électrode (181b) portée à un potentiel différent, de préférence deux autres électrodes (181b) portées à un potentiel différent, ces deux autres électrodes (181b) étant de préférence équidistantes de l'électrode de collecte (181a), au moins l'une desdites autres électrodes (181b) étant notamment utilisée ensuite comme électrode de collecte, l'électrode (181a) ayant servi précédemment d'électrode de collecte ne servant plus d'électrode de collecte et servant à générer le champ électrique.

3. Procédé selon l'une des deux revendications précédentes, les électrodes de collecte (181a, 181b) étant agencées selon une disposition matricielle, des potentiels différents V1, V2 étant appliqués sur les électrodes de collecte (181a, 181b) selon un agencement en damier, de manière à générer des champs électriques ayant au moins une composante latérale non nulle, le potentiel de chaque électrode de collecte (181a, 181b) passant de préférence alternativement du premier potentiel V1 au deuxième V2 et inversement.

4. Procédé selon la revendication 1, ladite au moins une autre zone étant une électrode dédiée (183) utilisée exclusivement comme électrode de champ pour générer ledit champ électrique sans servir à collecter de charges lues par le circuit de pixel associé, ladite électrode de champ (183) étant située entre au moins deux électrodes (181) collectant les charges photoélectriques, le champ à composante latérale étant généré entre chacune de ces électrodes de collecte (181) et l'électrode de champ (183), les électrodes de champ (183) étant disposées uniformément entre les électrodes de collecte (181), de manière qu'une électrode de champ (183) est entourée par plusieurs, notamment quatre, électrodes de collecte (181) adjacentes, l'électrode de champ (183) ayant de préférence une section inférieure à celle de l'électrode de collecte (181).

5. Procédé selon l'une quelconque des revendications précédentes, le champ électrique étant pulsé durant la lecture d'un pixel et/ou au moins un interrupteur de RESET (505a; 505b) est monté en parallèle du circuit de pixel (500) de sorte, lorsque fermé, à imposer une tension prédéfinie à l'électrode associée (181a ; 181b).

6. Procédé selon l'une quelconque des revendications précédentes, au moins l'une des électrodes étant polarisée par l'application d'une tension constante pendant le temps d'exposition, ladite électrode étant notamment polarisée avant le début du temps d'exposition, ladite électrode cessant de préférence d'être polarisée avant la fin du temps d'exposition, ladite électrode étant notamment polarisée avant le début du temps d'exposition avec une tension qui est inverse de celle de la polarisation pendant le temps d'exposition.

7. Procédé selon l'une quelconque des revendications précédentes, les électrodes (181, 183) étant métalliques, notamment comportant un ou plusieurs métaux choisis parmi : Al ; Al/TiW ; In ; Au ; Ti/Au ; Ti/Pt/Au ; Cu ; Cu/Au ; Ni ; Ni/Au ; Cr ; AuSn et leurs mélanges, en particulier les électrodes (181, 183) étant formées par une couche métallique supérieure d'un circuit de lecture (16) du capteur comprenant les circuits de pixels, présente en sortie de fonderie du capteur, notamment une couche métallique supérieure protégée ou non par une couche de passivation ouverte au niveau des électrodes.

8. Procédé selon l'une quelconque des revendications précédentes, les électrodes (181, 183) étant de contour circulaire en vue de face, étant notamment sous forme de billes ou les électrodes (181, 183) étant sous forme de structures imbriquées, notamment sous forme de peignes.

9. Procédé selon l'une quelconque des revendications précédentes, les électrodes (181, 183) étant déposées sur un circuit de lecture (16) du capteur, comprenant les circuits de pixels, avant le dépôt dudit milieu.

10. Procédé selon la revendication 7, les électrodes (181, 183) étant formées par une couche métallique supérieure d'un circuit de lecture (16) du capteur comprenant les circuits de pixels, présente en sortie de fonderie du capteur, notamment une couche métallique supérieure protégée ou non par une couche de passivation ouverte au niveau des électrodes.

11. Procédé selon l'une quelconque des revendications précédentes, le matériau photosensible comportant des nanocristaux (19), de préférence des points quantiques (Quantum dots), notamment colloïdaux ou de graphène, dispersés dans le milieu (15).

12. Procédé selon l'une quelconque des revendications 1 à 10, le matériau photosensible (191) étant déposé sous forme d'une ou plusieurs couches empilées au-dessus des électrodes (181, 183) ou le matériau photosensible (191) étant disposé sous forme d'une ou plusieurs couches s'étendant dans le sens de l'épaisseur entre les électrodes (181, 183) ou le matériau photosensible (191) étant intriqué et disposé de manière non ordonnée dans ledit milieu (15).

13. Capteur d'image SWIR, MWIR, LWIR, notamment pour la mise en œuvre du procédé selon l'une quelconque des revendications précédentes, comportant un milieu (15) comprenant au moins un matériau photosensible (19 ; 191) apte à générer des charges (190) par effet photoélectrique lorsque le capteur est exposé à une lumière incidente, et des électrodes de collecte (181) au contact dudit milieu (15), associées à des circuits de pixels, le milieu (15) ayant une face opposée à celle en contact avec les électrodes de collecte (181) qui est dépourvue de couche d'électrode externe , les circuits de pixels étant configurés pour créer au moins un champ électrique uniquement à composante latérale pour collecter les charges (190) sur au moins l'une des électrodes de collecte (181), permettant leur lecture par le circuit de pixel (500), la composante latérale du champ électrique étant générée en créant au moins une différence de potentiel entre ladite électrode de collecte (181) et au moins une autre zone du capteur étant une autre électrode de collecte ou une électrode de champ dédiée à la génération de ce champ,
cette autre zone étant située entre au moins deux électrodes de collecte (181).

## Patentansprüche

1. Verfahren zum Betreiben eines SWIR-, MWIR- oder LWIR-Bildsensors, umfassend ein Medium (15), das mindestens ein lichtempfindliches Material (19; 191) beinhaltet, das in der Lage ist, durch photoelektrischen Effekt Ladungen (190) zu erzeugen, wenn der Sensor einem einfallenden Licht ausgesetzt ist, und Sammelelektroden (181) in Kontakt mit dem Medium (15), die Pixelschaltungen (500) zugeordnet sind, wobei das Medium (15) eine zu derjenigen in Kontakt mit den Sammelelektroden (181) entgegengesetzte Seite hat, die keine äußere Elektrodenschicht aufweist, wobei bei dem Verfahren mindestens ein elektrisches Feld nur mit lateraler Komponente geschaffen wird, um die Ladungen (190) an mindestens einer der Sammelelektroden (181) zu sammeln, was ihr Auslesen durch die zugeordnete Pixelschaltung (500) ermöglicht, wobei die laterale Komponente des elektrischen Feldes erzeugt wird, indem mindestens eine Potentialdifferenz zwischen der Sammelelektrode (181) und mindestens einer weiteren Zone des Sensors geschaffen wird, die eine weitere Sammelelektrode oder eine zur Erzeugung dieses Feldes dedizierte Feldelektrode ist, die auf ein anderes Potential gebracht wird, wobei diese weitere Zone zwischen mindestens zwei Sammelelektroden (181) gelegen ist.

2. Verfahren nach dem vorhergehenden Anspruch, wobei mindestens eine weitere Zone eine weitere Sammelelektrode ist, wobei die Ausrichtung der lateralen Komponente des elektrischen Feldes sequentiell geändert wird, um die Ladungen sequentiell an verschiedenen jeweiligen Sammelelektroden (181a, 181b) zu sammeln, wobei vorzugsweise mindestens zwei benachbarte Elektroden (181a, 181b) abwechselnd unterschiedlichen Potentialen ausgesetzt werden, so dass die Ladungen an diesen Elektroden abwechselnd gesammelt werden, wobei die Ladungen insbesondere an einer gegebenen Sammelelektrode (181a) mithilfe eines elektrischen Feldes gesammelt werden, das mindestens eine laterale Komponente hat und das zwischen dieser und mindestens einer weiteren Elektrode (181b) erzeugt wird, die auf ein anderes Potential gebracht wird, vorzugsweise zwei weiteren Elektroden (181b), die auf ein anderes Potential gebracht werden, wobei diese beiden weiteren Elektroden (181b) vorzugsweise abstandsgleich zu der Sammelelektrode (181a) sind, wobei mindestens eine der weiteren Elektroden (181b) insbesondere anschließend als Sammelelektrode verwendet wird, wobei die Elektrode (181a), die zuvor als Sammelelektrode gedient hat, nicht mehr als Sammelelektrode dient und dazu dient, das elektrische Feld zu erzeugen.

3. Verfahren nach einem der beiden vorhergehenden Ansprüche, wobei die Sammelelektroden (181a, 181b) gemäß einer Matrixanordnung angeordnet sind, wobei unterschiedliche Potentiale V1, V2 an die Sammelelektroden (181a, 181b) gemäß einer Schachbrettanordnung angelegt werden, so dass elektrische Felder erzeugt werden, die mindestens eine laterale Komponente ungleich null haben, wobei das Potential jeder Sammelelektrode (181a, 181b) vorzugsweise abwechselnd von dem ersten Potential V1 zu dem zweiten Potential V2 und umgekehrt übergeht.

4. Verfahren nach Anspruch 1, wobei die mindestens eine weitere Zone eine dedizierte Elektrode (183) ist, die ausschließlich als Feldelektrode verwendet wird, um das elektrische Feld zu erzeugen, ohne dazu zu dienen, von der zugeordneten Pixelschaltung ausgelesene Ladungen zu sammeln, wobei die Feldelektrode (183) zwischen mindestens zwei die photoelektrischen Ladungen sammelnden Elektroden (181) gelegen ist, wobei das Feld mit lateraler Komponente zwischen jeder dieser Sammelelektroden (181) und der Feldelektrode (183) erzeugt wird, wobei die Feldelektroden (183) gleichmäßig zwischen den Sammelelektroden (181) angeordnet sind, so dass eine Feldelektrode (183) von mehreren, insbesondere vier, benachbarten Sammelelektroden (181) umgeben ist, wobei die Feldelektrode (183) vorzugsweise einen kleineren Querschnitt als die Sammelelektrode (181) hat.

5. Verfahren nach einem der vorhergehenden Ansprüche, wobei das elektrische Feld während des Auslesens eines Pixels gepulst wird und/oder mindestens ein RESET-Schalter (505a; 505b) parallel zu der Pixelschaltung (500) montiert ist, so dass er, wenn er geschlossen ist, der zugeordneten Elektrode (181a; 181b) eine vorgegebene Spannung aufprägt.

6. Verfahren nach einem der vorhergehenden Ansprüche, wobei mindestens eine der Elektroden durch das Anlegen einer konstanten Spannung während der Expositionszeit polarisiert wird, wobei die Elektrode insbesondere vor dem Beginn der Expositionszeit polarisiert wird, wobei die Elektrode vorzugsweise vor dem Ende der Expositionszeit nicht mehr polarisiert wird, wobei die Elektrode insbesondere vor dem Beginn der Expositionszeit mit einer Spannung polarisiert wird, die invers zu derjenigen der Polarisation während der Expositionszeit ist.

7. Verfahren nach einem der vorhergehenden Ansprüche, wobei die Elektroden (181, 183) metallisch sind, insbesondere ein oder mehrere Metalle umfassen, die ausgewählt sind aus: Al; Al/TiW; In; Au; Ti/Au; Ti/Pt/Au; Cu; Cu/Au; Ni; Ni/Au; Cr; AuSn und Mischungen davon, wobei die Elektroden (181, 183) insbesondere durch eine obere Metallschicht einer Ausleseschaltung (16) des die Pixelschaltungen beinhaltenden Sensors gebildet werden, die im Gusszustand des Sensors vorhanden ist, insbesondere eine obere Metallschicht, die durch eine an den Elektroden offene Passivierungsschicht geschützt ist oder nicht.

8. Verfahren nach einem der vorhergehenden Ansprüche, wobei die Elektroden (181, 183) in der Vorderansicht eine kreisförmige Kontur aufweisen, insbesondere in Form von Kugeln vorliegen, oder die Elektroden (181, 183) in Form von verschachtelten Strukturen vorliegen, insbesondere in Form von Kämmen.

9. Verfahren nach einem der vorhergehenden Ansprüche, wobei die Elektroden (181, 183) vor dem Abscheiden des Mediums auf einer Ausleseschaltung (16) des Sensors abgeschieden werden, der die Pixelschaltungen beinhaltet.

10. Verfahren nach Anspruch 7, wobei die Elektroden (181, 183) durch eine obere Metallschicht einer Ausleseschaltung (16) des Sensors, der die Pixelschaltungen beinhaltet, gebildet werden, die im Gusszustand des Sensors vorhanden ist, insbesondere eine obere Metallschicht, die durch eine an den Elektroden offene Passivierungsschicht geschützt ist oder nicht.

11. Verfahren nach einem der vorhergehenden Ansprüche, wobei das lichtempfindliche Material Nanokristalle (19) umfasst, vorzugsweise Quantenpunkte (Quantum dots), insbesondere kolloidale oder aus Graphen, die in dem Medium (15) dispergiert sind.

12. Verfahren nach einem der Ansprüche 1 bis 10, wobei das lichtempfindliche Material (191) in Form einer oder mehrerer über den Elektroden (181, 183) gestapelten Schichten abgeschieden wird oder das lichtempfindliche Material (191) in Form einer oder mehrerer Schichten angeordnet wird, die sich in Richtung der Dicke zwischen den Elektroden (181, 183) erstrecken, oder das lichtempfindliche Material (191) verschränkt ist und in dem Medium (15) in ungeordneter Weise angeordnet wird.

13. SWIR-, MWIR- oder LWIR-Bildsensor, insbesondere zur Durchführung des Verfahrens nach einem der vorhergehenden Ansprüche, umfassend ein Medium (15), das mindestens ein lichtempfindliches Material (19; 191) beinhaltet, das in der Lage ist, durch photoelektrischen Effekt Ladungen (190) zu erzeugen, wenn der Sensor einem einfallenden Licht ausgesetzt ist, und Sammelelektroden (181) in Kontakt mit dem Medium (15), die Pixelschaltungen zugeordnet sind, wobei das Medium (15) eine zu derjenigen in Kontakt mit den Sammelelektroden (181) entgegengesetzte Seite hat, die keine äußere Elektrodenschicht aufweist, wobei die Pixelschaltungen dazu ausgebildet sind, mindestens ein elektrisches Feld nur mit lateraler Komponente zu schaffen, um die Ladungen (190) an mindestens einer der Sammelelektroden (181) zu sammeln, was ihr Auslesen durch die Pixelschaltung (500) ermöglicht, wobei die laterale Komponente des elektrischen Feldes erzeugt wird, indem mindestens eine Potentialdifferenz zwischen der Sammelelektrode (181) und mindestens einer weiteren Zone des Sensors geschaffen wird, die eine weitere Sammelelektrode oder eine zur Erzeugung dieses Feldes dedizierte Feldelektrode ist, wobei diese weitere Zone zwischen mindestens zwei Sammelelektroden (181) gelegen ist.

## Claims

1. Method of operation of an SWIR, MWIR or LWIR image sensor, comprising a medium (15) comprising at least one photosensitive material (19; 191) which is able to generate charges (190) by means of the photoelectric effect when the sensor is exposed to incident light, and collection electrodes (181) in contact with said medium (15), which are associated with pixel circuits (500), the medium (15) having a face opposite the one in contact with the collection electrodes (181) which has no external electrode layer, in which method there is created at least one electrical field with only a lateral component in order to collect said charges (190) on at least one of said collection electrodes (181), making it possible for them to be read by the associated pixel circuit (500), wherein said lateral component of the electrical field is generated by creating at least one potential difference between said collection electrode (181) and at least one other zone of the sensor which is another collection electrode or a field electrode dedicated to generating this field, brought to a different potential, this other zone being situated between at least two collection electrodes (181).

2. Method according to the preceding claim, said at least one other zone being another collection electrode, wherein the orientation of the lateral component of the electrical field is changed sequentially in order to sequentially collect the charges on different respective collection electrodes (181a, 181b), preferably wherein at least two adjacent electrodes (181a, 181b) are alternately subjected to different potentials so as to alternately collect the charges on said electrodes, the charges notably being collected on a given collection electrode (181a) using an electrical field having at least one lateral component and which is generated between it and at least one other electrode (181b) brought to a different potential, preferably two other electrodes (181b) brought to a different potential, these two other electrodes (181b) preferably being equidistant from the collection electrode (181a), at least one of said other electrodes (181b) notably then being used as a collection electrode, the electrode (181a) having been used previously as a collection electrode no longer being used as a collection electrode and being used to generate the electrical field.

3. Method according to one of the two preceding claims, the collection electrodes (181a, 181b) being arranged according to a matrix arrangement, different potentials V1, V2 being applied to the collection electrodes (181a, 181b) according to a draughtboard arrangement, so as to generate electrical fields having at least one non-zero lateral component, the potential of each collection electrode (181a, 181b) preferably alternately switching from the first potential V1 to the second potential V2 and vice versa.

4. Method according to Claim 1, said at least one other zone being a dedicated electrode (183) used exclusively as a field electrode to generate said electrical field without being used to collect charges read by the associated pixel circuit, said field electrode (183) being situated between at least two electrodes (181) collecting the photoelectric charges, the field with a lateral component being generated between each of these collection electrodes (181) and the field electrode (183), the field electrodes (183) being arranged uniformly between the collection electrodes (181), so that a field electrode (183) is surrounded by several, notably four, adjacent collection electrodes (181), the field electrode (183) preferably having a section which is smaller than that of the collection electrode (181).

5. Method according to any one of the preceding claims, the electrical field being pulsed during the reading of a pixel and/or at least one RESET switch (505a; 505b) is connected in parallel with the pixel circuit (500) so as, when closed, to impose a predefined voltage on the associated electrode (181a; 181b).

6. Method according to any one of the preceding claims, at least one of the electrodes being biased by the application of a voltage which is constant during the exposure time, said electrode notably being biased before the start of the exposure time, said electrode preferably ceasing to be biased before the end of the exposure time, said electrode notably being biased before the start of the exposure time with a voltage which is the reverse of that of the biasing during the exposure time.

7. Method according to any one of the preceding claims, the electrodes (181, 183) being metallic, notably comprising one or more metals chosen from among: Al; Al/TiW; In; Au; Ti/Au; Ti/Pt/Au; Cu; Cu/Au; Ni; Ni/Au; Cr; AuSn and mixtures thereof, in particular the electrodes (181, 183) being formed by an upper metallic layer of a read circuit (16) of the sensor comprising the pixel circuits, which is present at the output of the casting of the sensor, notably an upper metallic layer protected or not by a passivation layer which is open at the electrodes.

8. Method according to any one of the preceding claims, the electrodes (181, 183) having a circular outline when seen from the front, notably being in the form of balls or the electrodes (181, 183) being in the form of nested structures, notably in the form of combs.

9. Method according to any one of the preceding claims, the electrodes (181, 183) being deposited on a read circuit (16) of the sensor, comprising the pixel circuits, before said medium is deposited.

10. Method according to Claim 7, the electrodes (181, 183) being formed by an upper metallic layer of a read circuit (16) of the sensor comprising the pixel circuits, which is present at the output of the casting of the sensor, notably an upper metallic layer protected or not by a passivation layer which is open at the electrodes.

11. Method according to any one of the preceding claims, the photosensitive material comprising nanocrystals (19), preferably quantum dots, notably colloidal or graphene quantum dots, dispersed in the medium (15).

12. Method according to any one of Claims 1 to 10, the photosensitive material (191) being deposited in the form of one or more layers stacked on top of the electrodes (181, 183) or the photosensitive material (191) being arranged in the form of one or more layers extending in the thickness direction between the electrodes (181, 183) or the photosensitive material (191) being nested and arranged in an unordered fashion in said medium (15).

13. SWIR, MWIR or LWIR image sensor, notably for implementing the method according to any one of the preceding claims, comprising a medium (15) comprising at least one photosensitive material (19; 191) which is able to generate charges (190) by means of the photoelectric effect when the sensor is exposed to incident light, and collection electrodes (181) in contact with said medium (15), which are associated with pixel circuits, the medium (15) having a face opposite the one in contact with the collection electrodes (181) which has no external electrode layer, the pixel circuits being configured to create at least one electrical field with only a lateral component in order to collect the charges (190) on at least one of the collection electrodes (181), making it possible for them to be read by the pixel circuit (500), the lateral component of the electrical field being generated by creating at least one potential difference between said collection electrode (181) and at least one other zone of the sensor which is another collection electrode or a field electrode dedicated to generating this field, this other zone being situated between at least two collection electrodes (181).
